# DEMANDE DE BREVET EUROPEEN

(11) **EP 1 355 361 A1**
(43) Date de publication de la demande: **22.10.2003**
(21) Numéro de dépôt: 02405316.7
(22) Date de dépôt: 18.04.2002
(51) Int. Cl.: H01L 29/739, H01L 29/88

(54) **Procédé pour créer une charge électrique dans le corps d'un composant semi-conducteur**

(71) Demandeur: Innovative Silicon SA, 1015 Lausanne (CH); Ecole Polytechnique Fédérale de Lausanne (EPFL), 1015 Lausanne (CH)
(72) Inventeur: Fazan, Pierre, 2525 Le Landeron (CH); Okhonin, Serguei, 1005 Lausanne (CH)
(74) Mandataire: Vinsome, Rex Martin

(57) **Abrégé**

L'invention concerne un procédé pour créer une charge électrique dans un transistor de type SOI, qui comprend une source (18), un drain (20), une grille (26) et un corps (22), et qui est formé sur un substrat comportant :
- une couche isolante (14),
- une première couche de matériau semi-conducteur (16) recouvrant la couche isolante (14) et dans laquelle sont constitués, par dopage, source (18), drain (20) et corps (22) dudit transistor, et
- un film diélectrique (24) disposé entre la source (18) et le drain (20) et revêtu d'une couche conductrice formant la grille (26).

La charge est crée en appliquant à la source (18), au drain (20) et à la grille (26) des potentiels choisis de manière à obtenir un effet tunnel à la jonction du corps (22) et du drain (20).

## Description

La présente invention concerne un procédé permettant de créer une charge dans un composant semi-conducteur tel qu'un transistor à effet de champ, de type SOI (de l'anglais « silicon on insulator »).

De tels transistors sont, par exemple, utilisés dans des mémoires connues sous le nom de DRAM (de l'anglais « Dynamic Random Access Memory), et décrits dans la demande de brevet EP 01810587.4. Ces mémoires comportent un circuit de commande et des cellules disposées dans une structure matricielle, chaque cellule étant formée d'un transistor à effet de champ, lequel comporte, de manière classique, un drain, une source, une grille, et un corps compris entre la source et le drain, fréquemment appelé du terme anglais de « body », la source, la grille et le drain constituant les bornes du transistor.

Selon les potentiels appliqués aux bornes du transistor, un canal se forme dans le corps, permettant la mobilité de particules chargées entre la source et le drain.

Comme expliqué dans le document EP mentionné ci-dessus, il est possible de créer, dans le corps, une charge électrique formée de particules (électrons ou trous) et qui semble être stockée dans une partie seulement du corps.

De manière classique pour une mémoire binaire de type DRAM, le transistor peut occuper deux états « 0 » et « 1 » qui sont fonction de la charge stockée. Pour un transistor de type NMOS, l'état « 1 » correspond à la présence, dans le corps, d'une charge électrique formée de trous en excès, alors que l'état « 0 » est défini par un corps dans lequel les trous sont en défaut. Les particules sont introduites dans la cellule par des impulsions appliquées par le circuit de commande aux bornes des transistors et, plus précisément, par ionisation par impact. Le courant à faire circuler dans le corps à cet effet est important en regard de la charge stockée.

Le but de la présente invention est de permettre la création d'une charge, dans le corps d'un composant semi-conducteur comportant un substrat muni d'une couche isolante et d'une couche de matériau semi-conducteur recouvrant la couche isolante et dans laquelle est formé ledit composant qui comprend un corps à l'intérieur duquel est stockée ladite charge. Ce but est atteint grâce au fait que ladite charge est créée par effet tunnel.

Ce procédé s'applique tout particulièrement à un transistor de type SOI.

Selon un premier mode de réalisation, l'invention s'applique à un transistor à effet de champ du type NMOS, qui comprend une source, un drain, une grille et un corps, et qui est formé sur un substrat comportant
- une couche isolante,
- une première couche de matériau semi-conducteur recouvrant la couche isolante et dans laquelle sont constitués, par dopage, source, drain et corps du transistor, et
- un film diélectrique disposé entre la source et le drain et revêtu d'une couche conductrice formant la grille.

Dans ce cas, la charge est créée par l'application d'une différence de tension entre la grille et le drain, cette différence de tension étant telle que, à l'interface du drain et du corps, les bandes de valence et de conduction du matériau semi-conducteur soient déformées de manière à amener, par effet tunnel, des électrons de la bande de valence dans la bande de conduction, permettant la formation d'électrons libres et de trous, les électrons étant extraits par le drain, alors que les trous migrent à l'intérieur du corps et y sont stockés.

Selon un deuxième mode de réalisation, l'invention s'applique à un transistor à effet de champ du type PMOS, qui comprend une source, un drain, une grille et un corps, et qui est formé sur un substrat comportant
- une couche isolante,
- une première couche de matériau semi-conducteur recouvrant la couche isolante et dans laquelle sont constitués, par dopage, source, drain et corps du transistor, et
- un film diélectrique disposé entre la source et le drain et revêtu d'une couche conductrice formant la grille.

Dans ce cas, la charge est créée par l'application d'une différence de tension entre la grille et le drain, cette différence de tension étant telle que, à l'interface du drain et du corps, les bandes de valence et de conduction du matériau semi-conducteur soient déformées de manière à amener, par effet tunnel, des électrons de la bande de valence dans la bande de conduction, permettant la formation d'électrons libres et de trous, les trous étant extraits par le drain, alors que les électrons migrent à l'intérieur du corps et y sont stockés.

D'autres caractéristiques de l'invention ressortiront de la description qui va suivre, faite en regard du dessin annexé, dans lequel:
- la figure 1 illustre deux procédés connus de création d'une charge dans le corps d'un transistor NMOS de type SOI, et
- la figure 2, relative au procédé selon l'invention, montre de manière schématique, en a la structure d'un transistor sur lequel est appliqué le procédé et en b l'effet de l'application d'une différence de tension positive entre le drain et la grille sur les bandes de valence et de conduction du semi-conducteur, à l'interface du corps et drain.

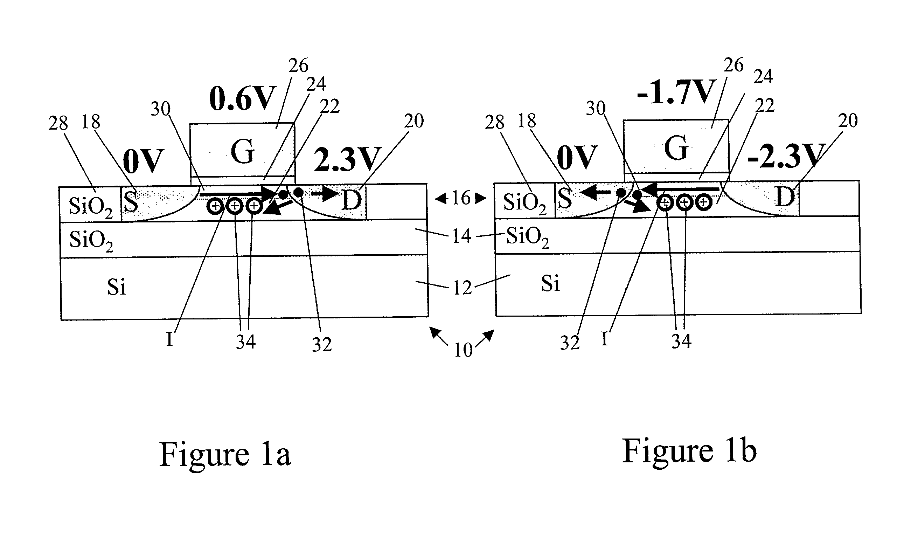

Les transistors représentés de manière très schématique sur la figure 1 sont de type SOI NMOS. Ils sont réalisés sur un substrat 10 comportant, superposées, une plaque de base 12 en silicium, une couche isolante 14 en oxyde de silicium ou en saphir, et une couche de silicium 16.

Les transistors sont obtenus par une succession d'opérations faisant appel à la photo-lithographie et au cours desquelles des couches sont partiellement enlevées, dopées, ou de nouvelles couches sont déposées.

De manière classique, ces transistors comportent, formés dans la couche 16, une source 18, un drain 20 et un corps 22 intercalé entre la source 16 et le drain 20. Le corps 22 est recouvert d'un film diélectrique 24 débordant légèrement sur la source 18 et le drain 20, et qui porte une grille 26. La couche 16 a été gravée autour de la source et du drain et remplacée par un cadre isolant 28, en oxyde de silicium. De la sorte, le corps 22 est isolé électriquement de son environnement. Les caractéristiques physiques de la source 18 et du drain 20 sont obtenues par dopage de la couche 16.

Sur la figure 1a, le transistor est commandé en appliquant respectivement à la source 18, à la grille 26 et au drain 20 des tensions nulle, de + 0,6 V et de + 2,3 V. La tension de + 0,6 V sur la grille a pour effet de former en surface du corps 22, à l'interface avec le film 24, une zone électriquement conductrice appelée canal et portant la référence 30. A cause de la différence de potentiel entre la source 18 et le drain 20, le canal 30 est parcouru par un courant I d'électrons dont l'énergie cinétique est suffisante pour provoquer, par ionisation par impact, des paires électrons-trous à l'interface du drain et du corps. Il se forme ainsi des électrons libres 32, extraits par le drain 20, et des trous 34 qui migrent dans la zone du corps 22 voisine de la couche isolante 14 et y sont stockés.

La figure 1b illustre un procédé similaire, mais dans lequel l'ionisation par impact se fait du côté de la source 18. Ici, la source 18 est aussi à 0V, alors que la grille 26 est à -1,7V et le drain 20 à -2,3 V. La tension appliquée à la grille 26 engendre la création du canal 30, parcouru par le courant I, d'électrons passant du drain 20 vers la source 18. Leur énergie cinétique est suffisante pour provoquer, par ionisation par impact, des paires électrons-trous à l'interface de la source 16 et du corps 22. Les électrons libres 32 en résultant sont extraits par la source 16 et les trous migrent dans la zone du corps 22 voisine de la couche isolante 14 où ils sont stockés.

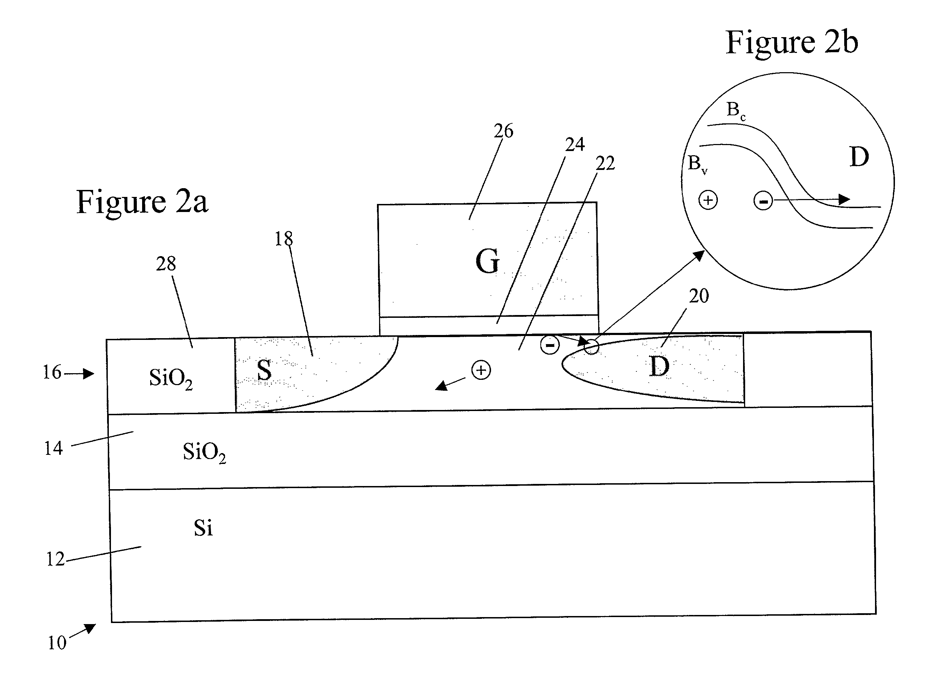

Le transistor représenté sur la figure 2a présente la même structure que ceux des figures 1a et 1b, les mêmes parties portant les mêmes références. De manière typique, la couche en matériau semi-conducteur 16 est en silicium.

Le transistor est fabriqué en technologie 0,13 µm, avec des densités de dopage, dans le corps 22, de 10¹⁸ atomes de type p par cm³ et, dans le drain 20, de 10²¹ atomes de type n par cm³. Le film 24 a une épaisseur de l'ordre de 2 nm.

Dans ce transistor, les tensions appliquées sont de 0V sur la source 18, de -1,5V sur la grille 26 et de +1V sur le drain 20. Il se produit, à l'interface du corps 22 et du drain 20, un effet tunnel dû au fait que les bandes de valence Bᵥ et de conduction B_{c}, qui sont schématiquement représentées sur la figure 2b, sont déformées. Le pliage de ces bandes peut être obtenu par un champ électrique typiquement de 1MV/cm. Il en résulte que des électrons sont extraits par le drain 20, alors que les trous qui leurs sont associés restent dans le corps 22.

Le procédé applique le phénomène physique connu sous le nom de « GIDL », abréviation de l'appellation anglaise « Gâte Induced Drain Leakage », décrit par exemple dans un article de Chi Chang et al. intitulé « Corner Field induced drain leakage in thin oxide MOSFETS », IEDM Technical Digest, page 714, 1987.

Durant la création de la charge, il n'y a pas d'autre courant que celui des électrons extraits du corps 22 par effet tunnel. La consommation est ainsi considérablement réduite.

Il a, en outre, été constaté que la charge pouvant être stockée dans le corps est environ deux fois plus grande que celle obtenue par un procédé classique. Cela semble provenir du fait que la charge est ici stockée dans tout le volume du corps 22, alors que, dans le procédé connu, cette charge est confinée dans la partie du corps 22 attenante à la couche isolante 14.

La description qui vient d'être faite concerne un transistor de type NMOS. Le même principe est applicable aux transistors de type PMOS. Dans ce cas, la tension sur la grille est positive, celle sur le drain négative, et ce sont des trous qui sont extraits du corps par le drain, alors que des électrons sont piégés.

Deux paramètres du transistor jouent un rôle particulièrement important pour assurer un stockage optimum. C'est, tout d'abord, l'épaisseur du film diélectrique, qui doit être aussi fin que possible, avantageusement inférieur à 2 nm pour un transistor fabriqué en technologie 0,13 µm. C'est, ensuite, le gradient du taux de dopage à la jonction du corps et du drain, qui doit être aussi élevé que possible. L'opération de dopage devra donc être effectuée de manière à éviter au maximum une diffusion des atomes de dopage du drain dans le corps.

Le procédé décrit ci-dessus est, bien entendu, applicable à des dispositifs comportant plusieurs transistors, disposés dans une structure matricielle définie par des ensembles de lignes et de colonnes, et formant ainsi une mémoire DRAM ou DRAM embarquée.

Dans une telle matrice, toutes les grilles 26 d'une même ligne, respectivement tous les drains 32 d'une même colonne sont reliés entre eux par une piste conductrice et sont, en conséquence, à un même potentiel, alors que les sources 18 sont toutes à la masse.

L'écriture d'une information dans une cellule donnée, se trouvant au croisement d'une ligne et d'une colonne, se fait en appliquant un potentiel de -1,5V sur la ligne et de +1V sur la colonne. Les lignes respectivement les colonnes non concernées se trouvent à un potentiel de 0V. De la sorte, une charge n'est créée que dans les cellules considérées. En effet, la charge n'est pas modifiée dans les transistors dont la source 18 et le drain 20 sont à 0V et la grille 26 à -1,5V. Il en est de même pour ceux dont la source 18 et la grille 26 sont à 0V et le drain 20 à + 1V, et pour ceux dont la source 18, le drain 20 et la grille 26 sont à 0V. Il va de soi que plusieurs cellules de la même lignes peuvent être commandées simultanément.

Le procédé selon l'invention peut être appliqué à d'autres dispositifs que les mémoires DRAM, en fait, à tout dispositif dans lequel une charge électrique doit être stockée durant un temps plus ou moins long.

## Revendications

1. Procédé pour créer une charge électrique dans le corps d'un composant semi-conducteur comportant un substrat (10) muni d'une couche isolante (14) et d'une couche de matériau semi-conducteur (16) recouvrant la couche isolante et dans laquelle est formé ledit composant qui comprend un corps (20) à l'intérieur duquel est stockée ladite charge, **caractérisé en ce que** ladite charge est créée par effet tunnel.

2. Procédé pour créer une charge électrique dans le corps d'un transistor à effet de champ du type NMOS, qui comprend une source (18), un drain (20), une grille (26) et un corps (22), et qui est formé sur un substrat comportant
- une couche isolante (14),
- une première couche de matériau semi-conducteur (16) recouvrant la couche isolante (14) et dans laquelle sont constitués, par dopage, source (18), drain (20) et corps (22) dudit transistor, et
- un film diélectrique (24) disposé entre la source (18) et le drain (20) et revêtu d'une couche conductrice formant la grille (26),
**caractérisé en ce que** ladite charge est créée par l'application d'une différence de tension entre la grille (26) et le drain (20), cette différence de tension étant telle que, à l'interface du drain (20) et du corps (22), les bandes de valence (Bᵥ) et de conduction (B_{c}) du matériau semi-conducteur soient déformées de manière à amener, par effet tunnel, des électrons de la bande de valence (Bᵥ) dans la bande de conduction (B_{c}), permettant la formation d'électrons libres et de trous, les électrons étant extraits par le drain (18), les trous migrant à l'intérieur dudit corps (22).

3. Procédé pour créer une charge électrique dans le corps d'un transistor à effet de champ du type PMOS, qui comprend une source (18), un drain (20), une grille (26) et un corps (22), et qui est formé sur un substrat comportant :
- une couche isolante (14),
- une première couche de matériau semi-conducteur (16) recouvrant la couche isolante (14) et dans laquelle sont constitués, par dopage, source (18), drain (20) et corps (22) dudit transistor, et
- un film diélectrique (24) disposé entre la source (18) et le drain (20) et revêtu d'une couche conductrice formant la grille (26),
**caractérisé en ce que** ladite charge est créée par l'application d'une différence de tension entre la grille (26) et le drain (20), cette différence de tension étant telle que, à l'interface du drain (20) et du corps (22), les bandes de valence (Bᵥ) et de conduction (B_{c}) du matériau semi-conducteur soient déformées de manière à amener, par effet tunnel, des électrons de la bande de valence (Bᵥ) dans la bande de conduction (B_{c}), permettant la formation d'électrons libres et de trous, les trous étant extraits par le drain (20), les électrons migrant à l'intérieur dudit corps (22).
